(19) Europäisches Patentamt / European Patent Office / Office européen des brevets

(11) **EP 4 760 748 A1**

(12) **EUROPEAN PATENT APPLICATION**
published in accordance with Art. 153(4) EPC

(43) Date of publication:
**17.06.2026  Bulletin 2026/25**

(21) Application number: **24852420.9**

(22) Date of filing: **12.08.2024**

(51) International Patent Classification (IPC):
**G21C 7/12** *(2006.01)*     **G21D 3/00** *(2006.01)*
**G21D 3/16** *(2006.01)*     **G06F 30/20** *(2020.01)*

(52) Cooperative Patent Classification (CPC):
**G06F 30/20; G21C 7/12; G21D 3/00; G21D 3/16**

(86) International application number:
**PCT/KR2024/011952**

(87) International publication number:
**WO 2025/034067 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **10.08.2023  KR 20230104636**

(71) Applicant: **Korea Hydro & Nuclear Power Co., Ltd
Gyeongju-si, Gyeongsangbuk-do 38120 (KR)**

(72) Inventors:
- **YU, Keuk Jong
  Daejeon 34101 (KR)**
- **LEE, Sang Seob
  Daejeon 34101 (KR)**
- **LEE, Jae Min
  Daejeon 34101 (KR)**

(74) Representative: **Habermann, Hruschka &
Schnabel
Patentanwälte
Montgelasstraße 2
81679 München (DE)**

(54) **METHOD FOR CONTROLLING PART STRENGTH CONTROL ELEMENT ASSEMBLY TO ENABLE TURBINE LOAD-FOLLOWING**

(57)    The present invention relates to a method for controlling a part strength control element assembly to enable turbine load-following, comprising the steps of: identifying operation driving characteristics of a part strength control element assembly according to turbine loads through simulation of power plant-simulation calculations with varying turbine load; determining a maximum insertion position within the core of the part strength control element assembly on the basis of the operation driving characteristics; deriving a target position of the part strength control element assembly according to turbine load on the basis of the maximum insertion position; and controlling the insertion position of the part strength control element assembly according to the target position.

**FIG. 1**

```
┌──────────────────────────────────┐
│ Identify operational driving      │
│ characteristics of                │──── S100
│ partial-strength control element  │
│ assembly based on turbine load    │
│ through plant simulation          │
│ calculation simulating change in  │
│ turbine load                      │
└──────────────────────────────────┘
              │
              ▼
┌──────────────────────────────────┐
│ Determine maximum insertion       │
│ position of                       │──── S200
│ partial-strength control element  │
│ assembly within reactor core      │
│ based on operational driving      │
│ characteristics                   │
└──────────────────────────────────┘
              │
              ▼
┌──────────────────────────────────┐
│ Derive target position of         │
│ partial-strength control element  │──── S300
│ assembly according to turbine     │
│ load based on maximum insertion   │
│ position                          │
└──────────────────────────────────┘
              │
              ▼
┌──────────────────────────────────┐
│ Control insertion position of     │
│ partial-strength control element  │──── S400
│ assembly according to target      │
│ position                          │
└──────────────────────────────────┘
```

**Description**

Technical Field

The present disclosure relates to a method for controlling a partial-strength control element assembly for turbine load-following.

Background Art

In nuclear power plants such as CE-type plants, OPR1000, and APR1400, a reactor control system drives control element assemblies using automatic control logic so as to enable a reactor to follow changes in turbine load. Such automatic control logic applies only to full strength control element assemblies among control element assemblies composed of partial-strength and full strength control element assemblies, while partial-strength control element assemblies (PSCEAs) are manually driven when necessary to adjust axial power distribution of the reactor.

That is, when a reactor output changes in response to a change in turbine load, the reactor control system needs to automatically control reactivity (reactor output), and an operator needs to manually drive (insert/withdraw) the partial-strength control element assemblies to stably control axial power distribution caused by the output change.

Accordingly, when frequent turbine load changes are required, such as during daily load-following operation, the burden on the operator caused by manual operation of the partial-strength control element assemblies may be significantly increased.

Disclosure

Technical Problem

Accordingly, the present disclosure is intended to provide a method for controlling a partial-strength control element assembly for turbine load-following.

Technical Solution

The object of the present disclosure is achieved by a method for controlling a partial-strength control element assembly for turbine load-following, the method comprising: identifying operational driving characteristics of the partial-strength control element assembly based on turbine load through a plant simulation calculation simulating a change in turbine load; determining a maximum insertion position of the partial-strength control element assembly within a reactor core based on the operational driving characteristics; deriving a target position of the partial-strength control element assembly according to turbine load based on the maximum insertion position; and controlling an insertion position of the partial-strength control element assembly according to the target position.

The operational driving characteristics may include at least one of: (1) whether the partial-strength control element assembly is inserted/withdrawn in response to a turbine load change; (2) a position of the partial-strength control element assembly within a reactor core with excellent output and axial power distribution control performance; (3) whether a proportionality exists between a minimum output during load-following and the maximum insertion position of the partial-strength control element assembly; and (4) whether there are differences in the maximum insertion position of the partial-strength control element assembly depending on output, core cycle, and burnup level.

The maximum insertion position of the partial-strength control element assembly within a reactor core may be different for each output, each cycle, and each burnup level.

The target position may be determined using a reactor core length, the maximum insertion position of the partial-strength control element assembly for each cycle and burnup level, turbine load, and a current reactor core output.

The target position may be determined by the following equation: Target Position = (Reactor Core Length-pslimit)/$A$*($B$-$A$)+pslimit, where pslimit denotes the maximum insertion position of the partial-strength control element assembly for each cycle and burnup level, A denotes a minimum turbine load, and B denotes a current reactor core output.

The controlling of the insertion position of the partial-strength control element assembly may include: comparing the target position with a current position to determine a deviation value and a deviation direction; and determining insertion speed and direction of the partial-strength control element assembly based on the deviation value and the deviation direction.

Advantageous Effects

According to the present disclosure, the method for controlling a partial-strength control element assembly for turbine load-following is provided.

Description of Drawings

FIG. 1 is a flowchart of a method for controlling a partial-strength control element assembly for turbine load-following according to an embodiment of the present disclosure;

FIG. 2 illustrates maximum insertion positions of the partial-strength control element assembly for respective burnup levels in a first cycle; and

FIG. 3 illustrates maximum insertion positions of the partial-strength control element assembly for respective burnup levels in an eighth cycle.

Mode for Invention

Hereinafter, the present disclosure will be described in detail with reference to the accompanying drawings.

The accompanying drawings are merely examples for illustrating the technical concept of the present disclosure in more detail, and the concept of the present disclosure is not limited by the drawings. In addition, in the accompanying drawings, dimensions, distances, and the like may be exaggerated relative to actual values to illustrate relationships among respective components.

Due to insertion characteristics of control elements driven in an upper portion of a reactor, when reactor output decreases, output may be biased toward a lower portion of the reactor. Additionally, due to a decrease in temperature at a reactor outlet (i.e., an upper portion of the reactor), output may be biased toward the upper portion of the reactor.

Due to such complex characteristics, each nuclear power plant controls axial power distribution of a reactor during output changes using various control element designs and control methods. The present disclosure analyzes and utilizes such physical characteristics using simulation methods, and proposes a control logic for partial-strength control element assemblies capable of automatically controlling axial power distribution during output adjustment of various types of nuclear power plants.

Hereinafter, the present disclosure will be described in detail with reference to the drawings.

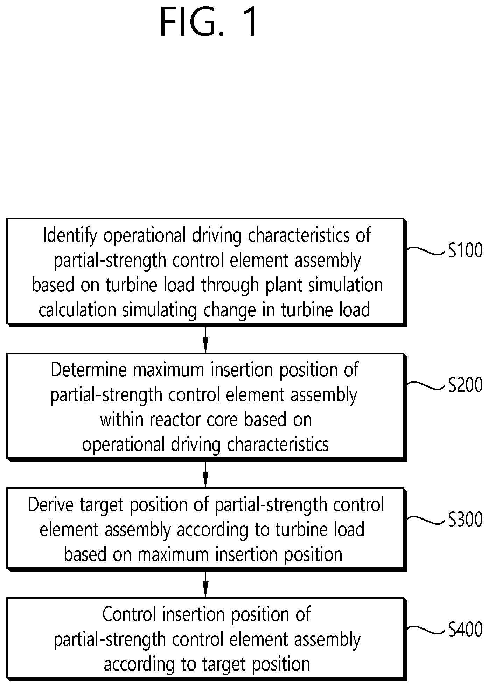

Referring to FIG. 1, a method for controlling a partial-strength control element assembly for turbine load-following according to the present disclosure will be described.

First, operational driving characteristics of the partial-strength control element assembly based on turbine load are identified through a plant simulation calculation simulating a change in turbine load (S100).

In this step, a physical correlation between reactor output/power distribution and the partial-strength control element assembly based on the turbine load change simulation is analyzed.

In this step, the simulation is performed according to output change scenarios. As an example of the output change scenarios, daily load-following operation may be used, but the present disclosure may not be limited thereto.

For example, daily load-following operation may include a simulation in which generator output is reduced from 100% to 50% over two hours, maintained at 50% for six hours, and then increased back to 100% over two hours, repeated in a 24-hour cycle.

During the simulation, reactor output is automatically controlled by a reactor control system, and axial power distribution is also automatically maintained at a target power distribution by adjusting the partial-strength control element assembly.

Such simulations are performed under various conditions (e.g., cycles and burnup levels) to analyze physical characteristics (position changes or the like) of partial-strength control element assemblies during turbine load changes in various types of reactors.

The operational driving characteristics obtained through such analyses include at least one of the following, and preferably include all four of the following:

(1) whether the partial-strength control element assembly is inserted/withdrawn in response to a turbine load change;

(2) a position of the partial-strength control element assembly within a reactor core with excellent output and axial power distribution control performance;

(3) whether a proportionality exists between a minimum output during load-following and the maximum insertion position of the partial-strength control element assembly; and

(4) whether there are differences in the maximum insertion position of the partial-strength control element assembly depending on output, core cycle, and burnup level.

Next, the maximum insertion position of the partial-strength control element assembly within a reactor core is determined based on the identified operational driving characteristics (S200).

The maximum insertion position of the partial-strength control element assembly within a reactor core may be different for each output, cycle, and burnup level.

Hereinafter, a length of the reactor core is exemplified as 380cm, but the present disclosure is not limited thereto.

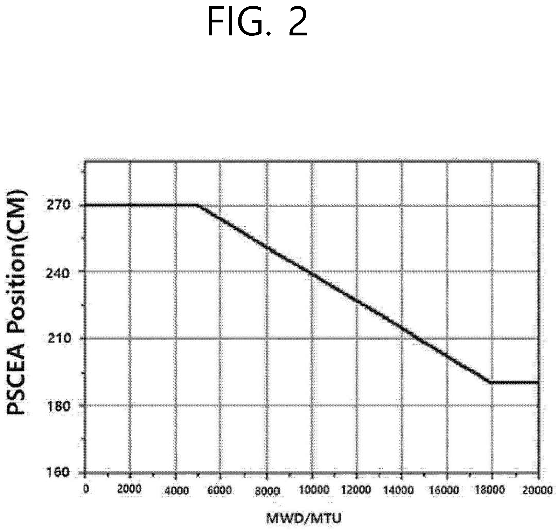

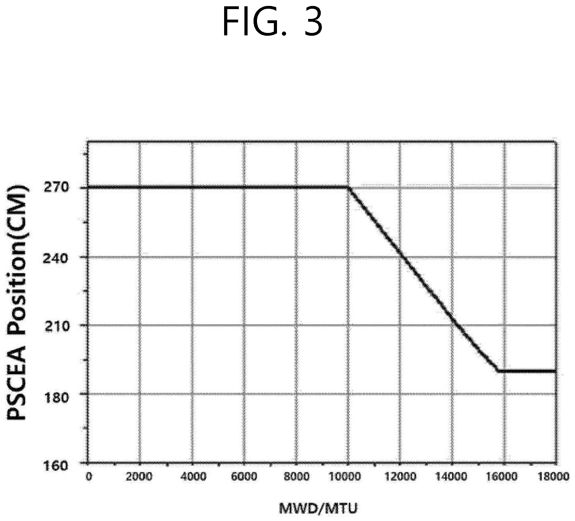

Based on the identified operational driving characteristics (physical characteristics) described above, a driving range of the partial-strength control element assembly may be limited to, for example, an upper half (180 to 380cm) of the reactor core, and the maximum insertion position may be determined based on core cycle and burnup level as shown in FIGS. 2 and 3.

FIG. 2 illustrates maximum insertion positions of the partial-strength control element assembly for respective burnup levels in a first cycle, and FIG. 3 illustrates maximum insertion positions of the partial-strength control element assembly for respective burnup levels in an eighth cycle.

FIG. 2 illustrates positions at which the partial-strength control element assembly may be inserted to the maximum extent within a reactor core (in case of load-following in which turbine output is reduced to 50%) at respective burnup levels in the first cycle (the initial core). In other words, a total height of the reactor core is 380cm measured from the bottom, and the control element inserted from the top may be inserted to a depth of approximately 270cm measured from the bottom.

FIGS. 2 and 3 were obtained using a nuclear power plant system performance analysis program. In order to obtain FIGS. 2 and 3, insertion positions of the partial-strength control element assembly where optimal output and power distribution are achieved were determined while automatically/manually adjusting a regulating control element assembly (automatic control based on output), the partial-strength control element assembly (manual control), and boron concentration (manual control) in the system performance analysis program. These positions were obtained under various burnup level conditions, and the obtained positions were optimally selected to obtain FIGS. 2 and 3.

In FIGS. 2 and 3, a y-axis represents maximum insertion positions of the control element, assuming 50% load-following, and an x-axis represents burnup levels in the corresponding cycle (beginning, middle, and end of the cycle). In other words, FIGS. 2 and 3 represent determination of optimal positions (in terms of output and power distribution control performance) of the partial-strength control element assembly at 50% output by identifying the operational characteristics of the partial-strength control element assembly under a load-following operation in which the output is reduced from 100% to 50% and then increased back to 100% using a nuclear power plant simulation code.

For example, referring to FIG. 2 corresponding to the first cycle, when output drops to 50% during load-following, the partial-strength control element assembly is positioned at approximately 270cm measured from the bottom of the reactor core. Referring to FIG. 3 corresponding to the eighth cycle, the partial-strength control element assembly may be inserted to a maximum extent down to a position of 270cm from the reactor core up to a burnup level of 10,000 MWD/MTU, and the maximum insertion position in the graph may vary linearly from 270cm to 190cm in a range of 10,000 to 15,000 MWD/MTU.

Furthermore, based on analysis results as illustrated in FIGS. 2 and 3, the driving range of the partial-strength control element assembly may be limited to the upper half of the reactor core (from 180cm to 380cm).

Thereafter, a target position of the partial-strength control element assembly according to turbine load is derived based on the determined maximum insertion position (S300).

The target position may be determined using a reactor core length, the maximum insertion position of the partial-strength control element assembly for each cycle and burnup level, turbine load, and a current reactor core output.

The target position may be defined by the following equation:

$$\text{Target Position} = (\text{Reactor Core Length} - \text{pslimit})/A * (B - A) + \text{pslimit}$$

where pslimit denotes the maximum insertion position of the partial-strength control element assembly for each cycle and burnup level, A denotes a minimum turbine load, and B denotes a current reactor core output.

Finally, an insertion position of the partial-strength control element assembly is controlled according to the derived target position (S400).

The controlling of the insertion position of the partial-strength control element assembly may include: (1) comparing the target position with a current position to determine a deviation value and a deviation direction; and (2) determining insertion speed and direction of the partial-strength control element assembly based on the deviation value and the deviation direction.

Once the target position of the partial-strength control element assembly to be controlled is generated from the equation in the previous step, the insertion speed and direction of the control element are determined based on a value and a sign (negative (-)/positive (+)) of the deviation by comparing the target position with the current position of the partial-strength control element assembly, and the partial-strength control element assembly is controlled based on the determined insertion speed and direction to adjust a position of the partial-strength control element assembly.

When turbine load-following operation is required, by using the partial-strength control element assembly control logic according to the present disclosure together with an existing reactor control system, reactor output and axial power distribution may be controlled without increasing an operator's burden with respect to control of the partial-strength control element assembly.

The foregoing embodiments are merely examples for describing the present disclosure, and the present disclosure is not limited thereto. Those skilled in the art to which the present disclosure pertains will appreciate that various modifications and changes may be made without departing from the spirit and scope of the present disclosure. Accordingly, the technical scope of the present disclosure should be defined by the appended claims.

**Claims**

1. A method for controlling a partial-strength control element assembly for turbine load-following, the method comprising:

   identifying operational driving characteristics of the partial-strength control element assembly based on turbine load through a plant simulation calculation simulating a change in turbine load;
   determining a maximum insertion position of the partial-strength control element assembly within a reactor core based on the operational driving characteristics;
   deriving a target position of the partial-strength control element assembly according to turbine load based on the maximum insertion position; and
   controlling an insertion position of the partial-strength control element assembly according to the target position.

2. The method of claim 1, wherein the operational driving characteristics include at least one of:

   (1) whether the partial-strength control element assembly is inserted/withdrawn in response to a turbine load change;
   (2) a position of the partial-strength control element assembly within a reactor core with excellent output and axial power distribution control performance;
   (3) whether a proportionality exists between a minimum output during load-following and the maximum insertion position of the partial-strength control element assembly; and
   (4) whether there are differences in the maximum insertion position of the partial-strength control element assembly depending on output, core cycle, and burnup level.

3. The method of claim 2, wherein the maximum insertion position of the partial-strength control element assembly within a reactor core is different for each output, each cycle, and each burnup level.

4. The method of claim 3, wherein the target position is determined using a reactor core length, the maximum insertion position of the partial-strength control element assembly for each cycle and burnup level, turbine load, and a current reactor core output.

5. The method of claim 4, wherein the target position is determined by the following equation:

$$\text{Target Position} = (\text{Reactor Core Length} - \text{pslimit})/A*(B-A) + \text{pslimit}$$

   where pslimit denotes the maximum insertion position of the partial-strength control element assembly for each cycle and burnup level, A denotes a minimum turbine load, and B denotes a current reactor core output.

6. The method of claim 5, wherein the controlling of the insertion position of the partial-strength control element assembly includes:

   comparing the target position with a current position to determine a deviation value and a deviation direction; and
   determining insertion speed and direction of the partial-strength control element assembly based on the deviation value and the deviation direction.

# FIG. 1

Identify operational driving characteristics of partial-strength control element assembly based on turbine load through plant simulation calculation simulating change in turbine load — S100

Determine maximum insertion position of partial-strength control element assembly within reactor core based on operational driving characteristics — S200

Derive target position of partial-strength control element assembly according to turbine load based on maximum insertion position — S300

Control insertion position of partial-strength control element assembly according to target position — S400

# FIG. 2

# FIG. 3

## INTERNATIONAL SEARCH REPORT

| International application No. |
|---|
| **PCT/KR2024/011952** |

**A. CLASSIFICATION OF SUBJECT MATTER**

**G21C 7/12**(2006.01)i; **G21D 3/00**(2006.01)i; **G21D 3/16**(2006.01)i; **G06F 30/20**(2020.01)i

According to International Patent Classification (IPC) or to both national classification and IPC

**B. FIELDS SEARCHED**

Minimum documentation searched (classification system followed by classification symbols)

G21C 7/12(2006.01); G21C 17/10(2006.01); G21C 17/108(2006.01); G21C 7/08(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 터빈 부하 추종(turbine load-following), 시뮬레이션(simulation), 부분강제어봉집합체(part strength control element assembly, PSCEA), 운전구동특성(operation driving characteristic), 목표위치(target position), 삽입위치(insertion position)

**C. DOCUMENTS CONSIDERED TO BE RELEVANT**

| Category* | Citation of document, with indication, where appropriate, of the relevant passages | Relevant to claim No. |
|---|---|---|
| X | KR 10-2006-0061038 A (DOOSAN HEAVY INDUSTRIES & CONSTRUCTION CO., LTD.) 07 June 2006 (2006-06-07)<br>See paragraphs [0002]-[0013]. | 1-2 |
| Y | | 3-4 |
| A | | 5-6 |
| Y | JP 2012-163438 A (TOKYO ELECTRIC POWER CO. INC.) 30 August 2012 (2012-08-30)<br>See paragraph [0003]. | 3-4 |
| Y | JP 07-306292 A (HITACHI LTD.) 21 November 1995 (1995-11-21)<br>See paragraph [0001]. | 3-4 |
| A | JP 2007-278812 A (HITACHI LTD.) 25 October 2007 (2007-10-25)<br>See claims 1-5. | 1-6 |

☑ Further documents are listed in the continuation of Box C.    ☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **07 November 2024** | **07 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2024/011952** |

**C. DOCUMENTS CONSIDERED TO BE RELEVANT**

| Category* | Citation of document, with indication, where appropriate, of the relevant passages | Relevant to claim No. |
| --- | --- | --- |
| A | JP 08-043583 A (HITACHI LTD. et al.) 16 February 1996 (1996-02-16)<br>See paragraphs [0017]-[0047] and claims 3-5. | 1-6 |

## INTERNATIONAL SEARCH REPORT
### Information on patent family members

International application No.

**PCT/KR2024/011952**

| Patent document cited in search report | | | Publication date (day/month/year) | Patent family member(s) | | | Publication date (day/month/year) |
|---|---|---|---|---|---|---|---|
| KR | 10-2006-0061038 | A | 07 June 2006 | None | | | |
| JP | 2012-163438 | A | 30 August 2012 | None | | | |
| JP | 07-306292 | A | 21 November 1995 | JP | 3256079 | B2 | 12 February 2002 |
| JP | 2007-278812 | A | 25 October 2007 | None | | | |
| JP | 08-043583 | A | 16 February 1996 | JP | 3091368 | B2 | 25 September 2000 |

Form PCT/ISA/210 (patent family annex) (July 2022)